# EUROPÄISCHE PATENTSCHRIFT

(11) **EP 4 025 807 B1**
(45) Veröffentlichungstag und Bekanntmachung des Hinweises auf die Patenterteilung: **31.05.2023**
(21) Anmeldenummer: 20764625.8
(22) Anmeldetag: 27.08.2020
(51) Int. Cl.: F16G 13/16

(54) **VORRICHTUNG UMFASSEND EINE ENERGIEFÜHRUNGSKETTE UND EINE GLEITAUFLAGE**
DEVICE COMPRISING AN ENERGY CHAIN AND A SLIDING TABLE
DISPOSITIF COMPRENANT UNE CHAÎNE D'ÉNERGIE ET UNE TABLE COULISSANTE

(30) Priorität: 02.09.2019 DE 202019104826 U
(43) Veröffentlichungstag der Anmeldung: 13.07.2022
(73) Patentinhaber: Tsubaki Kabelschlepp GmbH, 57482 Wenden-Gerlingen (DE)
(72) Erfinder: PÜTZ, Peter, 57462 Olpe (DE); BERGER, Daniel, 57078 Siegen (DE); EUL, Werner, 53844 Troisdorf (DE)
(74) Vertreter: Neumann, Ditmar
(86) Internationale Anmeldenummer: PCT/EP2020/074006
(87) Internationale Veröffentlichungsnummer: WO 2021/043668

(56) Entgegenhaltungen:
- DE-U1-202018 100 339

## Beschreibung

Erfindungsgemäß wird eine Vorrichtung umfassend eine Energieführungskette und eine Gleitauflage vorgestellt. Weiterhin betrifft die Erfindung eine Anordnung, die die Vorrichtung umfasst. Auch betrifft die Erfindung eine für die Vorrichtung geeignete Steuereinrichtung und ein dafür geeignetes Computerprogramm sowie ein maschinenlesbares Speichermedium mit diesem Computerprogramm.

Aus dem Stand der Technik sind Energieführungsketten bekannt, mit denen Kabel und Schläuche zwischen relativ zueinander beweglichen Körpern geführt werden können. Regelmäßig sind Energieführungsketten derart ausgebildet, dass Teile davon auf einer Gleitauflage gleiten. Um das Gleiten zu erleichtern, ist es bekannt, an Energieführungsketten Gleitschuhe anzubringen. Die Gleitschuhe haben eine Gleitoberfläche, mit der sie über die Gleitauflage gleiten können.

Eine Leitungsführungseinrichtung sowie eine Energieführungsvorrichtung mit einer Verschleißerkennungseinheit sind beispielsweise aus der DE 20 2018 100 339 U1 bekannt.

Beim Gebrauch der Energieführungskette kommt es an den Gleitschuhen zu Verschleiß. Daher sind die Gleitschuhe regelmäßig zu erneuern. Die Bestimmung des Verschleißes der Gleitschuhe ist gemäß Stand der Technik umständlich. Das kann einerseits dazu führen, dass die Gleitschuhe zu oft erneuert werden, wodurch unnötig hohe Kosten und ein unnötig hoher Wartungsaufwand entstehen. Andererseits kann dies dazu führen, dass das Überschreiten einer Verschleißgrenze nicht rechtzeitig erkannt wird, so dass es zu Schäden an der Energieführungskette und/oder an der Gleitauflage kommen kann.

Hiervon ausgehend liegt der vorliegenden Erfindung die Aufgabe zugrunde, die aus dem Stand der Technik bekannten Probleme zumindest teilweise zu überwinden und insbesondere eine Vorrichtung umfassend eine Energieführungskette und eine Gleitauflage bereitzustellen, bei der der Verschleiß von Gleitschuhen besonders einfach und zuverlässig bestimmt werden kann. Weiterhin sollen eine entsprechende Anordnung, eine entsprechende Steuereinrichtung, ein entsprechendes Computerprogramm und ein entsprechendes maschinenlesbares Speichermedium vorgestellt werden.

Diese Aufgaben werden gelöst mit den Merkmalen der unabhängigen Ansprüche. Weitere vorteilhafte Ausgestaltungen der Erfindung sind in den abhängig formulierten Ansprüchen angegeben. Die in den abhängig formulierten Ansprüchen einzeln aufgeführten Merkmale sind in technologisch sinnvoller Weise miteinander kombinierbar und können weitere Ausgestaltungen der Erfindung definieren. Darüber hinaus werden die in den Ansprüchen angegebenen Merkmale in der Beschreibung näher präzisiert und erläutert, wobei weitere bevorzugte Ausgestaltungen der Erfindung dargestellt werden.

Erfindungsgemäß wird eine Vorrichtung umfassend eine Energieführungskette und eine Gleitauflage vorgestellt. Die Energieführungskette weist eine Mehrzahl von Gleitschuhen mit einer jeweiligen Gleitoberfläche zum Gleiten auf der Gleitauflage auf. Die Gleitschuhe weisen jeweils ein Detektionselement auf, welches von der entsprechenden Gleitoberfläche durch eine jeweilige Verschleißschicht beabstandet angeordnet ist. Die Gleitauflage weist einen Sensor zur Bestimmung eines jeweiligen Abstandes zwischen dem Sensor und den Detektionselementen auf.

Mit der Energieführungskette können Kabel und Schläuche zwischen relativ zueinander beweglichen Körpern geführt werden. Dazu kann die Energieführungskette beispielsweise aus einer Mehrzahl von gelenkig miteinander verbundenen Gliedern aufgebaut sein.

Zumindest ein Teil der Energieführungskette kann auf der Gleitauflage gleiten. Die Gleitauflage ist nicht Teil der Energieführungskette. Die Gleitauflage ist vorzugsweise ortsfest.

Dass der erste Körper ortsfest ist, bedeutet, dass dieser bei üblicher Betrachtung zur Definition eines Bezugssystems herangezogen wird. Als erster Körper ist der größere der beiden Körper aufzufassen. Beispielsweise wird bei einem Kran mit Laufkatze der Kran als ortsfest und die Laufkatze als beweglich betrachtet. Der Kran ist in dem Beispiel der erste Körper und die Laufkatze der zweite Körper. Die Gleitauflage ist vorzugsweise mit dem ersten Körper verbunden. Die Gleitauflage ist auf die gleiche Art ortsfest wie der erste Körper.

Die Gleitauflage ist nicht Teil der Energieführungskette. Das bedeutet insbesondere, dass das Untertrum der Energieführungskette nicht durch das Untertrum gebildet ist. Die Gleitauflage ist vorzugsweise - anders als die Energieführungskette - nicht durch Verschiebung des beweglichen Endes der Energieführungskette relativ zum festen Ende der Energieführungskette veränderbar. Folglich besteht kein Bedarf für eine Ausbildung der Gleitauflage aus Gliedern. Daher ist es zur Vereinfachung der Konstruktion bevorzugt, dass die Gleitauflage nicht aus gelenkig miteinander verbundenen Gliedern gebildet ist.

Vorzugsweise ist die Energieführungskette zwischen einem ortsfesten ersten Körper und einem relativ zu diesem beweglichen zweiten Körper angeordnet. In dem Fall ist die Gleitauflage vorzugsweise mit dem ersten Körper verbunden.

Die Energieführungskette weist die Mehrzahl der Gleitschuhe auf, damit die Energieführungskette besonders gut über die Gleitauflage gleiten kann. Entsprechend sind die Gleitschuhe vorzugsweise auf eine solche Weise an der Energieführungskette angeordnet, dass die Gleitschuhe mit der Gleitauflage in Kontakt gebracht werden können. Je nach Stellung der Energieführungskette kann eine unterschiedliche Anzahl der Gleitschuhe mit der Gleitauflage in Kontakt stehen. Durch Verschiebung des zweiten Körpers relativ zum ersten Körper kann diese Zahl verändert werden.

Jeder der Gleitschuhe weist eine jeweilige Gleitoberfläche auf, mit der der Gleitschuhe über die Gleitauflage gleiten kann. Die Gleitoberfläche begrenzt eine Verschleißschicht des Gleitschuhs. Der Gleitschuh kann also über die Verschleißschicht mit der Gleitauflage in Kontakt stehen. Durch Reibung zwischen Verschleißschicht und Gleitauflage wird die Verschleißschicht mit der Zeit abgetragen, also in ihrer Dicke verringert. Dies ist hier als Verschleiß zu verstehen. Die Bestimmung des Verschleißes eines Gleitschuhes besteht also darin, die Dicke der Verschleißschicht zu bestimmen. Sobald die Dicke der Verschleißschicht einen Grenzwert unterschreitet, ist der Gleitschuh auszutauschen. Die Verschleißschicht ist vorzugsweise aus einem Kunststoff gebildet.

Mit der beschriebenen Vorrichtung kann der Verschleiß der Gleitschuhe besonders einfach und zuverlässig bestimmt werden. Das ist aufgrund der Detektionselemente der Gleitschuhe und des Sensors der Gleitauflage möglich. Steht ein Gleitschuh mit der Gleitauflage im Bereich des Sensors in Kontakt, ist die Verschleißschicht dieses Gleitschuhs zwischen dem entsprechenden Detektionselement und dem Sensor angeordnet. Der Abstand zwischen Detektionselement und Sensor ist mithin ein Maß für die Dicke der Verschleißschicht und insoweit für den Verschleiß des Gleitschuhs. Die Verschleißschicht kann sich genau zwischen Detektionselement und Sensor erstrecken. In dem Fall ist der Abstand zwischen Detektionselement und Sensor genau gleich der Dicke der Verschleißschicht. Es ist aber auch möglich, dass zwischen Verschleißschicht und Detektionselement und/oder zwischen Verschleißschicht und Sensor ein jeweiliger Abstand ausgebildet ist. Ein solcher Abstand kann als Offset von dem Abstand zwischen Detektionselement und Sensor abgezogen werden, um die Dicke der Verschleißschicht zu erhalten. Das Detektionselement kann beispielsweise an eine Schicht aus Kunststoff angrenzend angeordnet sein. In dem Fall ist die gesamte Kunststoffschicht die Verschleißschicht. Das Detektionselementen kann aber auch in eine Schicht aus Kunststoff eingelassen sein. In dem Fall ist nur der Teil der Kunststoffschicht als Verschleißschicht aufzufassen, der sich zwischen dem Detektionselement und der als Gleitoberfläche dienenden Oberfläche der Kunststoffschicht erstreckt.

Gemäß einer bevorzugten Ausführungsform weist die Vorrichtung weiterhin eine Steuereinrichtung auf, die zur Bestimmung eines Verschleißes der Verschleißschichten der Gleitschuhe aus den gemessenen Werten für den Abstand zwischen dem Sensor und den Detektionselementen eingerichtet ist.

Die Steuereinrichtung kann die Dicke der Verschleißschicht aus mit dem Sensor durchgeführten Messungen des Abstandes zwischen dem Sensor und dem entsprechenden Detektionselement bestimmen.

Gleitet die gesamte oder ein Teil der Energieführungskette über die Gleitauflage, werden die einzelnen Gleitschuhe nacheinander am Sensor vorbeigeführt. Somit kann der jeweilige Verschleiß der einzelnen Gleitschuhe nacheinander bestimmt werden. Wird das bewegliche Ende der Energieführungskette regelmäßig hin- und herbewegt, werden die einzelnen Gleitschuhe entsprechend regelmäßig am Sensor vorbeigeführt. Immer wenn ein Gleitschuh am Sensor vorbeigeführt wird, kann der Verschleiß dieses Gleitschuhs bestimmt werden. Auf diese Weise kann der zeitliche Fortschritt des Verschleißes der einzelnen Gleitschuhe bestimmt werden.

Der Verschleiß der einzelnen Gleitschuhe kann von der Steuereinrichtung einzelne bestimmt und ausgegeben werden. Möglich ist auch, dass lediglich eine jeweilige Warnung ausgegeben wird, sobald der Verschleiß eines der Gleitschuhe einen vorbestimmten Grenzwert überschritten hat. Eine solche Warnung kann für jeden Gleitschuh einzeln ausgegeben werden. Alternativ ist es möglich, dass die Steuereinrichtung lediglich eine Warnung ausgibt, sobald bei mindestens einem der Gleitschuhe der Verschleiß den vorbestimmten Grenzwert überschritten hat.

Es ist auch möglich, dass lediglich der Verschleiß des Gleitschuhs mit dem größten Verschleiß bestimmt wird. Das bedeutet, dass von der Steuereinrichtung lediglich der größte Verschleißwert bestimmt und ausgegeben wird. In dem Fall kann beispielsweise eine Warnung ausgegeben werden, sobald der größte Verschleiß einen vorbestimmten Grenzwert überschritten hat. Eine solche Ausgestaltung ist besonders einfach und kann für viele Anwendungen ausreichend sein. So kann beispielsweise vorgesehen sein, dass alle Gleitschuhe ausgetauscht werden, sobald der Verschleiß bei mindestens einem der Gleitschuhe den vorbestimmten Grenzwert überschritten hat. Dadurch kann erreicht werden, dass beispielsweise eine Anlage nur einmal zum Wechsel der Gleitschuhe stillstehen muss. Auch kann das Gleiten der Energieführungskette auf der Gleitauflage besonders ruckfrei erfolgen, wenn alle Gleitschuhe etwa gleichmäßig verschlissen sind.

Die Steuereinrichtung kann über ein Kabel oder drahtlos mit dem Sensor verbunden sein. Die Steuereinrichtung wiederum kann über ein Kabel oder drahtlos mit weiteren elektronischen Komponenten verbunden sein, um an diese Angaben zum Verschleißzustand der Gleitschuhe zu übermitteln. So kann die Steuereinrichtung beispielsweise per Funk ein Signal an eine Prozesssteuerung übermitteln, wenn der Prozess unterbrochen werden muss, um eine oder mehrere Gleitschuhe auszutauschen.

Gemäß einer weiteren bevorzugten Ausführungsform der Vorrichtung ist die Gleitauflage starr ausgebildet.

Die Gleitauflage ist nicht Teil der Energieführungskette. Insbesondere handelt es sich bei der Gleitauflage nicht um ein Untertrum der Energieführungskette, auf dem ein Obertrum der Energieführungskette gleiten könnte. In der vorliegenden Ausführungsform drückt sich dieser Umstand dadurch aus, dass die Gleitauflage starr ausgebildet ist. Die Gleitauflage kann also insbesondere nicht durch Verschiebung des beweglichen Endes der Energieführungskette relativ zum festen Ende der Energieführungskette gebogen oder auf andere Weise verändert werden. Eine derartige Veränderlichkeit ist hingegen bei der Energieführungskette gegeben. Diese kann bei der Energieführungskette beispielsweise dadurch gegeben sein, dass die Energieführungskette aus einer Vielzahl gelenkig miteinander verbundener Glieder gebildet ist. Insbesondere durch die bei der Gleitauflage nicht gegebene Veränderlichkeit unterscheidet sich die Gleitauflage von der Energieführungskette.

Gemäß einer weiteren bevorzugten Ausführungsform der Vorrichtung ist der Sensor auf, innerhalb oder unter einer Gleitschicht der Gleitauflage angeordnet.

Die Gleitauflage weist die Gleitschicht auf. Die Gleitschicht ist an der Oberfläche der Gleitauflage angeordnet, auf der die Gleitschuhe gleiten können. Der Abstand zwischen Detektionselement und Sensor kann berührungslos gemessen werden. Entsprechend ist es nicht hinderlich, wenn sich zwischen dem Sensor und der Oberfläche der Gleitauflage Material befindet, sofern dieses Material die Messung nicht beispielsweise aufgrund einer Abschirmungswirkung verhindert.

Gemäß einer weiteren bevorzugten Ausführungsform der Vorrichtung ist der Sensor dazu eingerichtet, nur den Abstand zwischen dem Sensor und dem zu einem bestimmten Zeitpunkt dem Sensor nächstgelegenen Detektionselement zu bestimmen.

Der Verschleiß eines Gleitschuhs kann in dieser Ausführungsform immer dann gemessen werden, wenn dieser Gleitschuh an dem Sensor vorbeigeführt wird. Um die Messung nicht zu verfälschen, kann der Sensor zu einem bestimmten Zeitpunkt nur ein einziges Detektionselement erfassen. Das kann beispielsweise dadurch erreicht werden, dass der Sensor so ausgebildet ist, dass der Sensor nur in einem geeignet begrenzten Raumbereich sensitiv ist, beispielsweise indem der Sensor entsprechende Abschirmelemente aufweist.

Gemäß einer weiteren bevorzugten Ausführungsform der Vorrichtung ist der Sensor dazu eingerichtet, den jeweiligen Abstand zwischen dem Sensor und den Detektionselementen senkrecht zur Gleitauflage zu bestimmen.

Die Dicke der Verschleißschicht senkrecht zur Gleitoberfläche ist ein geeignetes Maß für den Verschleiß eines Gleitschuhs. Entsprechend ist es bevorzugt, dass gerade diese Dicke bestimmt wird. Das ist möglich durch Messung des Abstandes zwischen dem Sensor und dem jeweiligen Detektionselement senkrecht zur Gleitauflage. Erreicht werden kann eine derartige Messung beispielsweise dadurch, dass der Sensor nur in einem geeignet begrenzten Raumbereich sensitiv ist, beispielsweise indem der Sensor entsprechende Abschirmelemente aufweist.

Gemäß einer weiteren bevorzugten Ausführungsform der Vorrichtung ist ein festes Ende der Energieführungskette mit der Gleitauflage verbunden.

Ausgehend von der Gleitauflage beginnt die Energieführungskette mit dem festen Ende und kann daran anschließend ein Untertrum, einen Umlenkbereich und ein Obertrum bilden, welches mit dem beweglichen Ende der Energieführungskette endet. Das Obertrum kann ganz oder teilweise auf der Gleitauflage gleiten. Je nach Stellung der Energieführungskette kann an das feste Ende der Energieführungskette anschließend auch unmittelbar ein Umlenkbereich der Energieführungskette ausgebildet sein.

Gemäß einer weiteren bevorzugten Ausführungsform der Vorrichtung entspricht ein Abstand zwischen dem Sensor und dem festen Ende der Energieführungskette höchstens einem Drittel einer Länge der Gleitauflage.

Wenn der Sensor hinreichend nahe am festen Ende der Energieführungskette angeordnet ist, können mit dem Sensor alle Gleitschuhe nacheinander erfasst werden. Wäre der Sensor zu weit vom festen Ende der Energieführungskette entfernt in der Gleitauflage angeordnet, könnten nur die Gleitschuhe nahe des beweglichen Endes der Energieführungskette am Sensor vorbeigeführt werden. Für viele Anwendungen ist der Sensor hinreichend nahe am festen Ende der Energieführungskette angeordnet, wenn der Abstand zwischen dem Sensor und dem festen Ende der Energieführungskette höchstens einem Drittel der Länge der Gleitauflage entspricht.

Der Abstand zwischen Sensor und festem Ende ist parallel zur Oberfläche der Gleitauflage definiert. Unter der Länge der Gleitauflage ist die Ausdehnung der Oberfläche der Gleitauflage zu verstehen, die für die Gleitschuhe zugänglich ist. Anfang und Ende der Länge der Gleitauflage bestimmen sich also aus den Positionen des ersten und letzten Gleitschuhs der Energieführungskette in den beiden extremen Stellungen, die das bewegliche Ende der Energieführungskette einnehmen kann.

Gemäß einer weiteren bevorzugten Ausführungsform der Vorrichtung liegt ein Abstand zwischen dem Sensor und dem festen Ende der Energieführungskette im Bereich zwischen 0,8 und 1,2 m.

In dieser Ausführungsform ist es bevorzugt, dass die Energieführungskette eine Länge im Bereich von 5 bis 20 m aufweist.

Gemäß einer weiteren bevorzugten Ausführungsform der Vorrichtung sind die Detektionselemente aus einem Metall gebildet.

Metalle lassen sich über verschiedene berührungslose Messverfahren erfassen. Entsprechend kann der Abstand zwischen dem Sensor und einem metallischen Detektionselement mit einem dieser Verfahren bestimmt werden.

Besonders genau sind berührungslose Messungen unter Verwendung magnetischer Materialien. Entsprechend ist es gemäß einer weiteren bevorzugten Ausführungsform der Vorrichtung vorgesehen, dass die Detektionselemente aus einem magnetischen Material gebildet sind.

Gemäß einer weiteren bevorzugten Ausführungsform der Vorrichtung ist der Sensor einer der folgenden:
- ein induktiver Näherungsschalter,
- ein kapazitiver Näherungsschalter,
- ein magnetischer Näherungsschalter,
- ein optischer Näherungsschalter,
- ein Ultraschall-Näherungsschalter.

Ein Näherungsschalter kann auch als (An)näherungsinitiator, Annäherungsschalter, oder (An)näherungssensor bezeichnet werden. Es handelt sich um einen Sensor, der berührungslos auf Annäherung reagiert.

Induktive Näherungsschalter reagieren sowohl auf ferromagnetische als auch auf nichtmagnetische metallische Gegenstände. Kapazitive Näherungsschalter reagieren sowohl auf metallische als auch nichtmetallische Gegenstände. Magnetische Näherungsschalter reagieren auf magnetische Gegenstände. Als magnetischer Näherungsschalter kommen insbesondere ein sogenannter Reed-Schalter oder ein Hallsensor in Betracht. Optische Näherungsschalter reagieren auf Lichtreflexion von einem Gegenstand. Ultraschall-Näherungsschalter werten die Reflexion eines Ultraschallsignals an einem Gegenstand als Hindernis aus.

Als mit dem Näherungsschalter zu erfassende Gegenstände dienen bei der beschriebenen Vorrichtung die Detektionselemente.

Als ein weiterer Aspekt der Erfindung wird eine Anordnung vorgestellt, die einen ortsfesten ersten Körper, einen relativ zu diesem beweglichen zweiten Körper und eine wie beschrieben ausgebildete Vorrichtung aufweist. Ein festes Ende der Energieführungskette ist über die Gleitauflage mit dem ersten Körper verbunden.

Als ein weiterer Aspekt der Erfindung wird eine Steuereinrichtung für eine wie beschrieben ausgebildete Vorrichtung vorgestellt. Die Steuereinrichtung ist zur Bestimmung eines Verschleißes der Verschleißschichten der Gleitschuhe aus den gemessenen Werten für den Abstand zwischen dem Sensor und den Detektionselementen eingerichtet.

Als ein weiterer Aspekt der Erfindung wird ein Computerprogramm für eine wie beschrieben ausgebildete Steuereinrichtung vorgestellt. Das Computerprogramm ist zur Bestimmung eines Verschleißes der Verschleißschichten der Gleitschuhe aus den gemessenen Werten für den Abstand zwischen dem Sensor und den Detektionselementen eingerichtet.

Als ein weiterer Aspekt der Erfindung wird ein maschinenlesbares Speichermedium vorgestellt, auf dem ein wie beschrieben ausgebildetes Computerprogramm gespeichert ist.

Die beschriebenen besonderen Vorteile und Ausgestaltungsmerkmale der beschriebenen Vorrichtung sind auf die beschriebene Anordnung, die beschriebene Steuereinrichtung, das beschriebene Computerprogramm und das beschriebene maschinenlesbare Speichermedium anwendbar und übertragbar, und umgekehrt.

Die Erfindung sowie das technische Umfeld werden nachfolgend anhand der Figuren näher erläutert. Es ist darauf hinzuweisen, dass die Erfindung durch die gezeigten Ausführungsbeispiele nicht beschränkt werden soll. Insbesondere ist es, soweit nicht explizit anders dargestellt, auch möglich, Teilaspekte der in den Figuren erläuterten Sachverhalte zu extrahieren und mit anderen Bestandteilen und Erkenntnissen aus der vorliegenden Beschreibung und/oder Figuren zu kombinieren. Insbesondere ist darauf hinzuweisen, dass die Figuren und insbesondere die dargestellten Größenverhältnisse nur schematisch sind. Gleiche Bezugszeichen bezeichnen gleiche Gegenstände, so dass ggf. Erläuterungen aus anderen Figuren ergänzend herangezogen werden können. Es zeigen:
- Fig. 1:: eine schematische Seitenansicht einer erfindungsgemäßen Anordnung,
- Fig. 2:: eine detailliertere schematische Darstellung eines Teils der Anordnung aus Fig. 1.

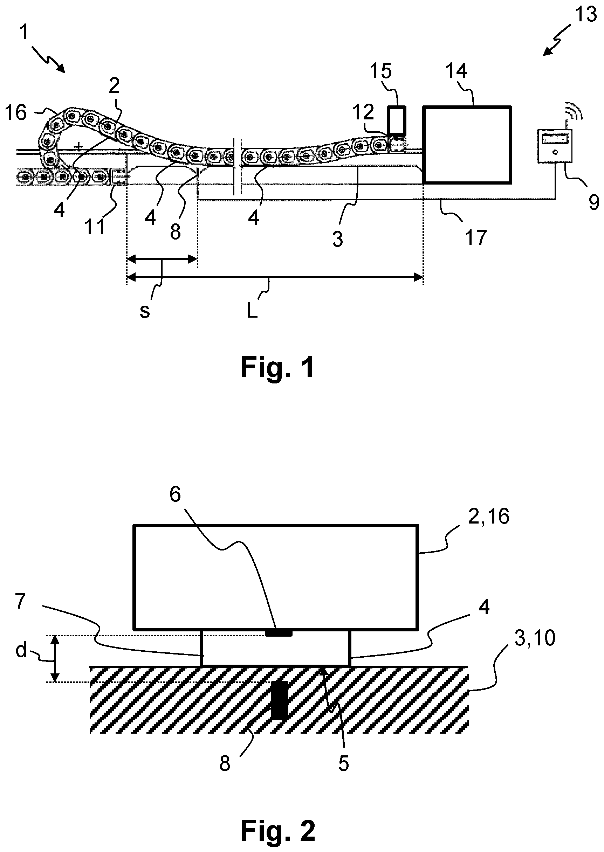

Fig. 1 zeigt eine Anordnung 13 umfassend einen ortsfesten ersten Körper 14 und einen relativ zu diesem beweglichen zweiten Körper 15. Weiterhin umfasst die Anordnung 13 eine Vorrichtung 1. Die Vorrichtung 1 umfasst eine Energieführungskette 2 und eine Gleitauflage 3. Mittels mehrerer Gleitschuhe 4 kann die Energieführungskette 2 über die Gleitauflage 3 gleiten. Die Gleitauflage 3 ist starr ausgebildet. Die Energieführungskette 2 ist durch eine Vielzahl von Gliedern 16 gebildet, die gelenkig miteinander verbunden sind. Beispielhaft ist eines der Glieder 16 mit einem Bezugszeichen versehen. Ein festes Ende 11 der Energieführungskette 2 ist über die Gleitauflage 3 mit dem ersten Körper 14 verbunden. Ein bewegliches Ende 12 der Energieführungskette 2 ist mit dem zweiten Körper 15 verbunden.

Innerhalb der Gleitauflage 3 ist ein Sensor 8 angeordnet. Ein Abstand s zwischen dem Sensor 8 und dem festen Ende 11 der Energieführungskette 2 entspricht in der gezeigten Ausführungsform weniger als einem Drittel einer Länge L der Gleitauflage 3 und liegt im Bereich zwischen 0,8 und 1,2 m. Der Sensor 8 kann aber auch an jeder anderen Stelle der Gleitauflage 3 angeordnet sein. Der Sensor 8 ist über ein Kabel 17 mit einer Steuereinrichtung 9 verbunden. Ein mit der Steuereinrichtung 9 ermitteltes Ergebnis kann, wie angedeutet, per Funk beispielsweise an eine Prozesssteuerung übermittelt werden.

Fig. 2 zeigt eine detailliertere schematische Darstellung eines Teils der Anordnung 13 aus Fig. 1. Gezeigt ist ein Glied 16 der Energieführungskette 2. An dem Glied 16 ist ein Gleitschuh 4 mit einer Gleitoberfläche 5 angeordnet, über die der Gleitschuh 4 in der gezeigten Situation mit der Oberfläche der Gleitauflage 3 in Kontakt steht. Von der Gleitauflage 3 ist eine Gleitschicht 10 teilweise gezeigt.

Die Gleitoberfläche 5 ist die in der Darstellung von Fig. 2 untere Begrenzung des Gleitschuhs 4.

Der Gleitschuh 4 weist ein Detektionselement 6 auf, welches von der Gleitoberfläche 5 durch eine Verschleißschicht 7 beabstandet angeordnet ist. Das Detektionselement 6 ist vorzugsweise aus einem magnetischen Metall gebildet. Bei Verwendung eines induktiven Näherungsschalters beispielsweise kann das Detektionselement aber auch aus einem nichtmagnetischen Material gebildet sein.

Der Sensor 8 der Gleitauflage 3 ist zur Bestimmung eines jeweiligen Abstandes d zwischen dem Sensor 8 und den Detektionselementen 6 eingerichtet. Der Sensor 8 ist dazu eingerichtet, nur den Abstand d zwischen dem Sensor 8 und dem zu einem bestimmten Zeitpunkt dem Sensor 8 nächstgelegenen Detektionselement 6 zu bestimmen. Der Sensor 8 ist weiterhin dazu eingerichtet, den jeweiligen Abstand d zwischen dem Sensor 8 und den Detektionselementen 6 senkrecht zur Gleitauflage 3 zu bestimmen. Bei dem Sensor 8 kann es sich um einen induktiven, kapazitiven, magnetischen oder optischen Näherungsschalter oder um einen Ultraschall-Näherungsschalter handeln.

Die in Fig. 1 gezeigte Steuereinrichtung 9 ist zur Bestimmung eines Verschleißes der Verschleißschichten 7 der Gleitschuhe 4 aus den gemessenen Werten für den Abstand d zwischen dem Sensor 8 und den Detektionselementen 6 eingerichtet.

Bei der beschriebenen Vorrichtung 1 ist in eine Gleitauflage 3 ein Sensor 8 integriert, mit dem ein Abstand d zu Detektionselementen 6 in Gleitschuhen 4 einer Energieführungskette 2 gemessen werden kann. Daraus kann besonders einfach und zuverlässig auf den Verschleiß der Gleitschuhe 4 geschlossen werden.

### Bezugszeichenliste

- 1: Vorrichtung
- 2: Energieführungskette
- 3: Gleitauflage
- 4: Gleitschuh
- 5: Gleitoberfläche
- 6: Detektionselement
- 7: Verschleißschicht
- 8: Sensor
- 9: Steuereinrichtung
- 10: Gleitschicht
- 11: festes Ende
- 12: bewegliches Ende
- 13: Anordnung
- 14: erster Körper
- 15: zweiter Körper
- 16: Glied
- 17: Kabel

- d: Abstand
- s: Abstand
- L: Länge

## Patentansprüche

1. Vorrichtung (1) umfassend eine Energieführungskette (2) und eine Gleitauflage (3), wobei die Energieführungskette (2) eine Mehrzahl von Gleitschuhen (4) mit einer jeweiligen Gleitoberfläche (5) zum Gleiten auf der Gleitauflage (3) aufweist, wobei die Gleitschuhe (4) jeweils ein Detektionselement (6) aufweisen, welches von der entsprechenden Gleitoberfläche (5) durch eine jeweilige Verschleißschicht (7) beabstandet angeordnet ist, **dadurch gekennzeichnet, dass** die Gleitauflage (3) einen Sensor (8) zur Bestimmung eines jeweiligen Abstandes (d) zwischen dem Sensor (8) und den Detektionselementen (6) aufweist.

2. Vorrichtung (1) nach Anspruch 1, weiterhin aufweisend eine Steuereinrichtung (9), die zur Bestimmung eines Verschleißes der Verschleißschichten (7) der Gleitschuhe (4) aus den gemessenen Werten für den Abstand (d) zwischen dem Sensor (8) und den Detektionselementen (6) eingerichtet ist.

3. Vorrichtung (1) nach einem der vorstehenden Ansprüche, wobei die Gleitauflage (3) starr ausgebildet ist.

4. Vorrichtung (1) nach einem der vorstehenden Ansprüche, wobei der Sensor (8) auf, innerhalb oder unter einer Gleitschicht (10) der Gleitauflage (3) angeordnet ist.

5. Vorrichtung (1) nach einem der vorstehenden Ansprüche, wobei der Sensor (8) dazu eingerichtet ist, nur den Abstand (d) zwischen dem Sensor (8) und dem zu einem bestimmten Zeitpunkt dem Sensor (8) nächstgelegenen Detektionselement (6) zu bestimmen.

6. Vorrichtung (1) nach einem der vorstehenden Ansprüche, wobei der Sensor (8) dazu eingerichtet ist, den jeweiligen Abstand (d) zwischen dem Sensor (8) und den Detektionselementen (6) senkrecht zur Gleitauflage (3) zu bestimmen.

7. Vorrichtung (1) nach einem der vorstehenden Ansprüche, wobei ein festes Ende (11) der Energieführungskette (2) mit der Gleitauflage (3) verbunden ist.

8. Vorrichtung (1) nach Anspruch 7, wobei ein Abstand (s) zwischen dem Sensor (8) und dem festen Ende (11) der Energieführungskette (2) höchstens einem Drittel einer Länge (L) der Gleitauflage (3) entspricht.

9. Vorrichtung (1) nach einem der Ansprüche 7 oder 8, wobei ein Abstand (s) zwischen dem Sensor (8) und dem festen Ende (11) der Energieführungskette (2) im Bereich zwischen 0,8 und 1,2 m liegt.

10. Vorrichtung (1) nach einem der vorstehenden Ansprüche, wobei die Detektionselemente (6) aus einem Metall gebildet sind.

11. Vorrichtung (1) nach einem der vorstehenden Ansprüche, wobei die Detektionselemente (6) aus einem magnetischen Material gebildet sind.

12. Vorrichtung (1) nach einem der vorstehenden Ansprüche, wobei der Sensor (8) einer der folgenden ist:
- ein induktiver Näherungsschalter,
- ein kapazitiver Näherungsschalter,
- ein magnetischer Näherungsschalter,
- ein optischer Näherungsschalter,
- ein Ultraschall-Näherungsschalter.

13. Anordnung (13) umfassend einen ortsfesten ersten Körper (14), einen relativ zu diesem beweglichen zweiten Körper (15) und eine Vorrichtung (1) gemäß einem der Ansprüche 1 bis 12, wobei ein festes Ende (11) der Energieführungskette (2) über die Gleitauflage (3) mit dem ersten Körper (14) verbunden ist.

14. Steuereinrichtung (9) für eine Vorrichtung (1) nach einem der Ansprüche 1 bis 12, wobei die Steuereinrichtung (9) zur Bestimmung eines Verschleißes der Verschleißschichten (7) der Gleitschuhe (4) aus den gemessenen Werten für den Abstand (d) zwischen dem Sensor (8) und den Detektionselementen (6) eingerichtet ist.

15. Computerprogramm für eine Steuereinrichtung (9) gemäß Anspruch 14, wobei das Computerprogramm zur Bestimmung eines Verschleißes der Verschleißschichten (7) der Gleitschuhe (4) aus den gemessenen Werten für den Abstand (d) zwischen dem Sensor (8) und den Detektionselementen (6) eingerichtet ist.

16. Maschinenlesbares Speichermedium, auf dem ein Computerprogramm gemäß Anspruch 15 gespeichert ist.

## Claims

1. Device (1) comprising an energy chain (2) and a sliding table (3), wherein the energy chain (2) has a plurality of sliding shoes (4) with a respective sliding surface (5) for sliding on the sliding table (3), wherein the sliding shoes (4) respectively have a detection element (6) which is arranged separated from the corresponding sliding surface (5) by a respective wearing layer (7), **characterized in that** the sliding table (3) has a sensor (8) for determining a respective distance (d) between the sensor (8) and the detection elements (6).

2. Device (1) according to Claim 1, furthermore having a control unit (9) which is adapted to determine a wear of the wearing layers (7) of the sliding shoes (4) from the measured values of the distance (d) between the sensor (8) and the detection elements (6).

3. Device (1) according to one of the preceding claims, wherein the sliding table (3) is configured rigidly.

4. Device (1) according to one of the preceding claims, wherein the sensor (8) is arranged on, inside or below a sliding layer (10) of the sliding table (3).

5. Device (1) according to one of the preceding claims, wherein the sensor (8) is adapted to determine only the distance (d) between the sensor (8) and the detection element (6) lying closest to the sensor (8) at a particular instant.

6. Device (1) according to one of the preceding claims, wherein the sensor (8) is adapted to determine the respective distance (d) between the sensor (8) and the detection elements (6) perpendicularly to the sliding table (3).

7. Device (1) according to one of the preceding claims, wherein a fixed end (11) of the energy chain (2) is connected to the sliding table (3).

8. Device (1) according to Claim 7, wherein a distance (s) between the sensor (8) and the fixed end (11) of the energy chain (2) corresponds at most to one third of a length (L) of the sliding table (3).

9. Device (1) according to one of Claims 7 and 8, wherein a distance (s) between the sensor (8) and the fixed end (11) of the energy chain (2) lies in the range of between 0.8 and 1.2 m.

10. Device (1) according to one of the preceding claims, wherein the detection elements (6) are formed from a metal.

11. Device (1) according to one of the preceding claims, wherein the detection elements (6) are formed from a magnetic material.

12. Device (1) according to one of the preceding claims, wherein the sensor (8) is one of the following:
- an inductive proximity switch,
- a capacitive proximity switch,
- a magnetic proximity switch,
- an optical proximity switch,
- an ultrasonic proximity switch.

13. Arrangement (13) comprising a static first body (14), a second body (15) which is movable relative thereto, and a device (1) according to one of Claims 1 to 12, wherein a fixed end (11) of the energy chain (2) is connected to the first body (14) via the sliding table (3).

14. Control unit (9) for a device (1) according to one of Claims 1 to 12, wherein the control unit (9) is adapted to determine a wear of the wearing layers (7) of the sliding shoes (4) from the measured values of the distance (d) between the sensor (8) and the detection elements (6).

15. Computer program for a control unit (9) according to Claim 14, wherein the computer program is adapted to determine a wear of the wearing layers (7) of the sliding shoes (4) from the measured values of the distance (d) between the sensor (8) and the detection elements (6).

16. Machine-readable storage medium on which a computer program according to Claim 15 is stored.

## Revendications

1. Dispositif (1) comprenant une chaîne de transport d'énergie (2) et un support de glissement (3), la chaîne de transport d'énergie (2) présentant une pluralité de patins de glissement (4) avec une surface de glissement respective (5) pour glisser sur le support de glissement (3), les patins de glissement (4) présentant chacun un élément de détection (6), qui est agencé à distance de la surface de glissement (5) correspondante par une couche d'usure (7) respective, **caractérisé en ce que** le support de glissement (3) présente un capteur (8) pour déterminer une distance (d) respective entre le capteur (8) et les éléments de détection (6).

2. Dispositif (1) selon la revendication 1, présentant en outre un appareil de commande (9) qui est adapté pour déterminer une usure des couches d'usure (7) des patins de glissement (4) à partir des valeurs mesurées pour la distance (d) entre le capteur (8) et les éléments de détection (6).

3. Dispositif (1) selon l'une quelconque des revendications précédentes, dans lequel le support de glissement (3) est configuré sous forme rigide.

4. Dispositif (1) selon l'une quelconque des revendications précédentes, dans lequel le capteur (8) est agencé sur, dans ou sous une couche de glissement (10) du support de glissement (3).

5. Dispositif (1) selon l'une quelconque des revendications précédentes, dans lequel le capteur (8) est adapté pour déterminer uniquement la distance (d) entre le capteur (8) et l'élément de détection (6) situé le plus près du capteur (8) à un moment donné.

6. Dispositif (1) selon l'une quelconque des revendications précédentes, dans lequel le capteur (8) est adapté pour déterminer la distance (d) respective entre le capteur (8) et les éléments de détection (6) perpendiculairement au support de glissement (3).

7. Dispositif (1) selon l'une quelconque des revendications précédentes, dans lequel une extrémité fixe (11) de la chaîne de transport d'énergie (2) est reliée au support de glissement (3).

8. Dispositif (1) selon la revendication 7, dans lequel une distance (s) entre le capteur (8) et l'extrémité fixe (11) de la chaîne de transport d'énergie (2) correspond au plus à un tiers d'une longueur (L) du support de glissement (3).

9. Dispositif (1) selon l'une quelconque des revendications 7 ou 8, dans lequel une distance (s) entre le capteur (8) et l'extrémité fixe (11) de la chaîne de transport d'énergie (2) se situe dans la plage comprise entre 0,8 et 1,2 m.

10. Dispositif (1) selon l'une quelconque des revendications précédentes, dans lequel les éléments de détection (6) sont formés en un métal.

11. Dispositif (1) selon l'une quelconque des revendications précédentes, dans lequel les éléments de détection (6) sont formés en un matériau magnétique.

12. Dispositif (1) selon l'une quelconque des revendications précédentes, dans lequel le capteur (8) est l'un des suivants :
- un détecteur de proximité inductif,
- un détecteur de proximité capacitif,
- un détecteur de proximité magnétique,
- un détecteur de proximité optique,
- un détecteur de proximité à ultrasons.

13. Agencement (13) comprenant un premier corps fixe (14), un deuxième corps (15) mobile par rapport à celui-ci et un dispositif (1) selon l'une quelconque des revendications 1 à 12, dans lequel une extrémité fixe (11) de la chaîne de transport d'énergie (2) est reliée au premier corps (14) par l'intermédiaire du support de glissement (3).

14. Appareil de commande (9) pour un dispositif (1) selon l'une quelconque des revendications 1 à 12, dans lequel l'appareil de commande (9) est adapté pour déterminer une usure des couches d'usure (7) des patins de glissement (4) à partir des valeurs mesurées pour la distance (d) entre le capteur (8) et les éléments de détection (6).

15. Programme informatique pour un appareil de commande (9) selon la revendication 14, dans lequel le programme informatique est adapté pour déterminer une usure des couches d'usure (7) des patins de glissement (4) à partir des valeurs mesurées pour la distance (d) entre le capteur (8) et les éléments de détection (6).

16. Support de stockage lisible par machine sur lequel est stocké un programme informatique selon la revendication 15
